# EUROPEAN PATENT SPECIFICATION

(11) **EP 0 805 617 B1**
(45) Date of publication and mention of the grant of the patent: **12.04.2000**
(21) Application number: 97107101.4
(22) Date of filing: 29.04.1997
(51) Int. Cl.: H05K 7/02, H01R 9/22

(54) **Integrated terminal board-filter assembly, particularly for electric household appliances**
Klemmbrett mit integriertem Entstörfilter insbesondere für elektrische Haushaltgeräte
Panneau de raccordement muni d'un filtre d'interférence en particulier pour appareils électroménagers

(30) Priority: 30.04.1996 IT TO960347
(43) Date of publication of application: 05.11.1997
(73) Proprietor: I.T.W. Fastex Italia S.p.A., 10156 Torino (IT); Miller Europe S.p.A., 20098 S. Giuliano Milanese (IT)
(72) Inventor: Bianchi, Raoul, c/o ITW Ispracontrols, 21043 Castiglione Olona (IT); Bassi, Alberto, 10100 Torino (IT)
(74) Representative: Jorio, Paolo

(56) References cited:
- FR-A- 2 698 733
- GB-A- 2 190 547

## Description

The present invention relates to an integrated terminal board-filter assembly for supplying electric household appliances, e.g. washing machines, dishwashers, etc. (See e.g. GB-A-2 190 547.)

For some time now, electric safety regulations require that the supply devices of electric household appliances be fitted with electronic filters for reducing or eliminating radiofrequency noise. As of present, such filters are manufactured as separate devices, which are subsequently fitted to the appliances, close to the contacts by which the current from the supply lead is distributed to the various appliance components (pumps, resistors, thermostats, etc.). Besides increasing the time taken to assemble the appliance, and hence manufacturing cost, such a system may also result in poor efficiency of the filter, due to bad electrical connections between the filter and the contacts.

It is an object of the present invention to overcome the aforementioned drawbacks, and more specifically, to provide a terminal board-filter assembly fittable to the appliance in one single operation.

According to the present invention, there is provided an integrated terminal board-filter assembly, in particular for electric household appliances, comprising a main body made of electrically insulating material and defining an inner cavity housing the preassembled, prewired components of an electronic filter; and a number of electric contacts; characterized by comprising:
- a bracket projecting laterally from one end of the main body and also made of electrically insulating material; the bracket being formed integrally in one piece with the main body; and said number of electric contacts being provided at and integral with the bracket, and so as to be connected electrically to the components of the filter;
- a cable clamping device formed integrally in one piece with a free end of the bracket opposite the main body; and
- snap-on fastening means for connecting the assembly to a support casing, and which are provided at least at said cable clamping device, on a mating surface connecting the assembly to the casing and defined by at least a respective face of the main body and/or the bracket.

More specifically, the main body is open laterally to enable access to said cavity, which is filled with a solid insulating resin in which said components of the electronic filter are embedded; and said number of electric contacts project directly from said main body, from the bracket side, through a wall of the main body from which the bracket extends integrally.

This therefore provides for a compact, low-cost integrated unit combining the functions of a filter, terminal board and cable clamping device, which is perfectly operative prior to assembly, and which is assembled in a single snap-on operation.

According to a preferred embodiment, the bracket is in the form of a Z-shaped stirrup, and the stirrup and main body are so sized as to enable the terminal board to be prewired and inserted from the outside into the casing seat in one single operation.

More specifically, the assembly according to the invention provides for straightforward, low-cost electrical connection of the contacts and components of the electronic filter; the contacts being blanked from a single metal sheet and subsequently co-molded with the main body and the bracket on an injection molding press; and the filter components being easily assembled, through the opening in the main body, directly to the terminals of the contacts inside the main body, and then sealed in fluidtight manner by filling the open cavity with a fluid resin, which is then allowed to set.

A non-limiting embodiment of the present invention will be described by way of example with reference to the accompanying drawings, in which:
Figure 1 shows a view in perspective of a terminal board-filter assembly in accordance with the present invention;
Figure 2 shows, schematically, the way in which the Figure 1 assembly is fitted to the casing, shown only partly in section, of an electric household appliance;
Figures 3 and 4 show details of a preferred variation of the Figure 1 terminal board.

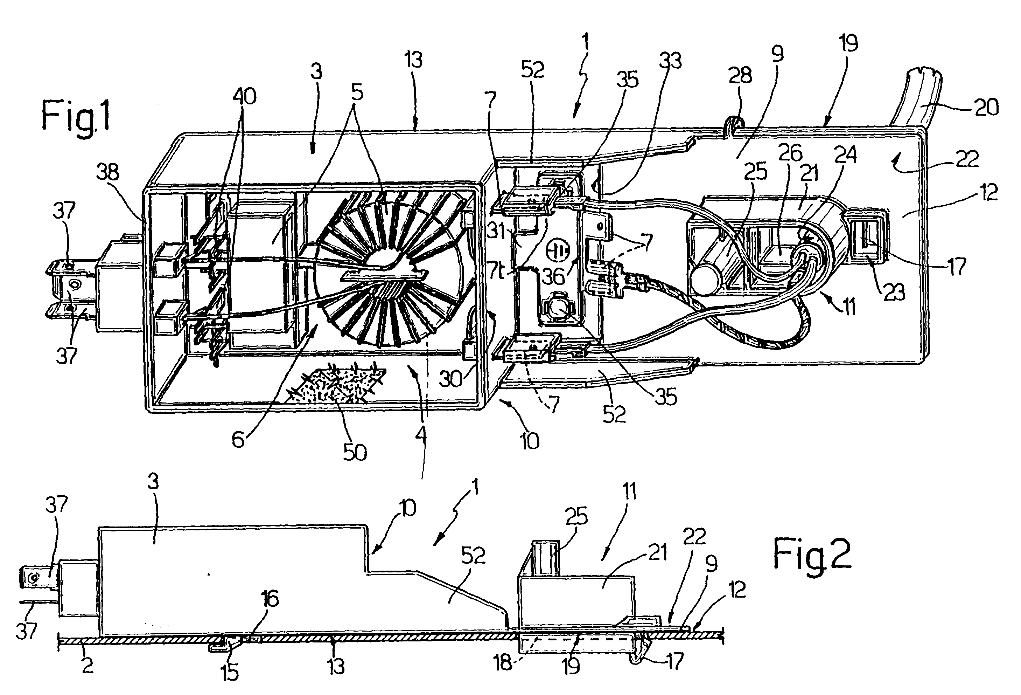

Number 1 in Figures 1 and 2 indicates an integrated terminal board-filter assembly for fitment to the inner side of a metal casing 2 of a known electric household appliance (not shown for the sake of simplicity). Assembly 1, which, in Figure 1, is shown from the side facing inwards of the appliance, comprises a substantially parallelepiped main body 3 made of electrically insulating material (e.g. plastic or ceramic) and defining an inner cavity 4 housing the preassembled, prewired components 5 of a known electronic radiofrequency filter 6 not described in detail for the sake of simplicity. Assembly 1 also comprises a bracket 9 defined by a flat rectangular plate projecting laterally from one end 10 of main body 3; and a number of electric contacts 7, at least one of which is a ground contact 7t. According to the invention, bracket 9 is also made of electrically insulating material, and is formed integrally in one piece with main body 3; and contacts 7 are located at bracket 9, so as to be integral with bracket 9 and, at the same time, connected electrically and mechanically to components 5 of filter 6.

According to the invention, assembly 1 also comprises a cable clamping device 11 formed integrally in one piece with the free end 12 of bracket 9 opposite main body 3; and, at clamping device 11 and main body 3, snap-on fastening means for connecting assembly 1 to casing 2 are provided on a mating surface for connecting assembly 1 to casing 2 and defined by a face 13 of main body 3 and by a face 19 of bracket 9.

In the example shown, face 13 of main body 3 and face 19 of bracket 9 are flush with each other to form a single continuous flat mating surface facing casing 2; and said snap-on fastening means are defined by two L-shaped tabs 15 (only one shown in Figure 2) formed in one piece with body 3, projecting from face 13, and insertable bayonet-fashion inside respective openings 16 formed through casing 2, and by a flexible tooth 17 formed in one piece with bracket 9, projecting from face 19, and which clicks beneath the edge of a through opening 18 formed through casing 2 at the portion for the passage of a known cable 20 for supplying the appliance.

Clamping device 11 may be of any known type fittable through opening 18, and preferably comprises a sleeve element 21 formed in one piece through and perpendicularly to bracket 9, and projecting partly from face 19 and partly from a flat opposite face 22 of bracket 9 parallel to face 19. Sleeve 21 is formed integrally in one piece with tooth 17 - which is housed partially inside a seat 23 formed through end 12 of bracket 9 - and comprises a through inner seat 24 for cable 20, and, to the side, a nut screw 25. Clamping device 11 also comprises a wedge-shaped cable clamping element 26 insertable gradually inside seat 24, alongside cable 20 (Figure 1), by a screw (not shown) screwed inside nut screw 25 through clamping element 26. Elements 3, 9, 11 and respective components are all formed integrally in one piece, e.g. injection molded from synthetic plastic resin. More specifically clamping element 26 is formed in one piece with bracket 9, to which it is connected laterally by a known flexible tongue 28 (shown only partly in Figure 1).

Contacts 7, including ground contact 7t, are so formed as to project directly from body 3 on the same side as bracket 9 and through the same wall 30 of body 3 from which bracket 9 projects integrally from body 3. More specifically, ground contact 7t comprises a flat T-shaped tab 31 coplanar with bracket 9 and substantially flush with the surface defined by faces 13 and 19, by being housed inside a through opening 33 formed in bracket 9 and flush with wall 30 of body 3. Tab 31 projects from body 3 through wall 30 and into opening 33 so as to directly contact casing 2 when, in use, tabs 15 and teeth 17 are inserted inside respective openings 16 and 18.

Tab 31 comprises two opposite threaded holes 35 for fitment to casing 2, for receiving respective known grounding screws (not shown), and which are formed through the ends of the wings of the T formed by tab 31. On the front edge 36 common to both said wings, tab 31 comprises a further two projecting contacts 7, which are normally male faston types formed in one piece with tab 31; and a second number of contacts 37 project from body 3 through a lateral wall 38 of body 3 opposite wall 30 from which bracket 9 extends.

According to a preferred embodiment, body 3 is open laterally. More specifically, the upper face opposite bottom faces 13 and 19 is absent to enable access from the outside to the whole of cavity 4, and so enable components 5 to be assembled easily inside cavity 4, e.g. to conducting plates 40 co-molded inside cavity 4 and already connected as desired to contacts 7 and/or 37, e.g. by blanking the contacts and conducting plates from the same metal sheet. To fluidtight seal filter 6, cavity 4 is filled with a solid insulating resin 50, e.g. a synthetic plastic resin or insulating wax, in which components 5 are embedded, and which is poured into cavity 4, after assembling components 5, and then allowed to set.

The flat plate defining bracket 9 projects from the full width of body 3, parallel to and on the opposite side to the open side of body 3; and two ribs 52 for protecting contacts 7 are provided at opening 33, on opposite longitudinal sides of bracket 9, project from body 3 in one piece with body 3 and bracket 9, and taper (slope downwards) towards the free end 12 of bracket 9.

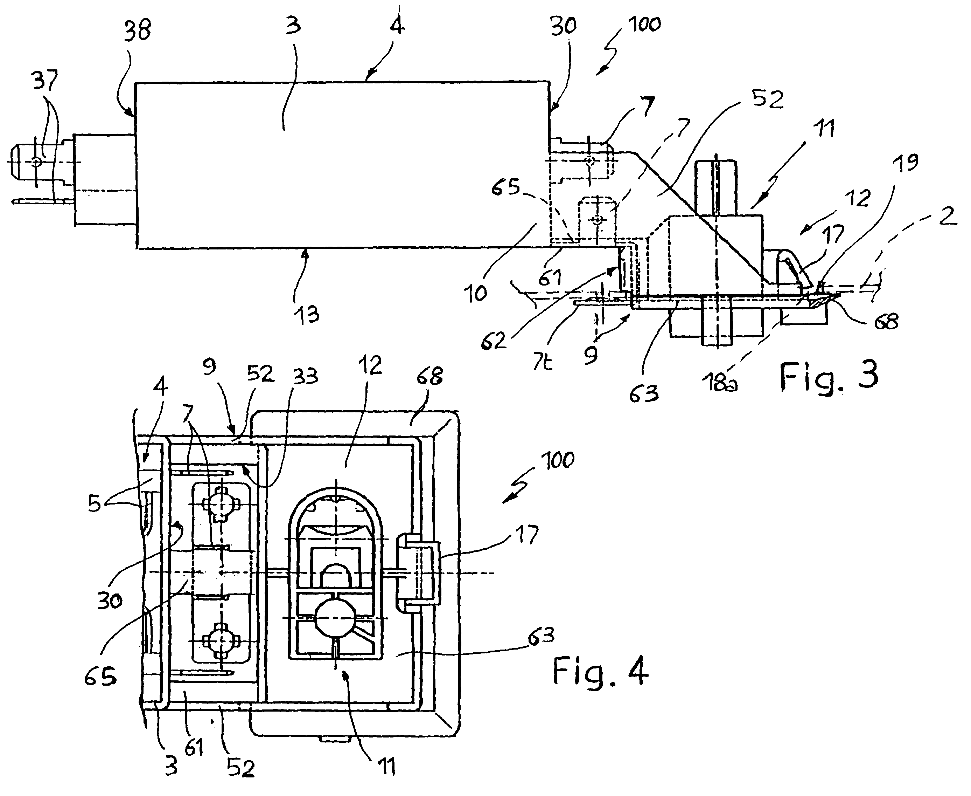

Figures 3 and 4, in which any details similar or identical to those already described are indicated using the same numbering system, shows a preferred variation 100 of assembly 1, wherein bracket 9 is in the form of a right-angle Z-shaped stirrup comprising a first flat portion 61 projecting from body 3 and flush with face 13 opposite cavity 4; a second portion 62 perpendicular to portion 61; and a third portion 63 parallel to portion 61 and projecting from portion 62, on the opposite side to portion 61.

The upper face 19 of portion 63 facing body 3 defines the mating surface for connection to casing 2, and which, in this case (Figure 3), is connected to the outside of casing 2. As before, bracket 9 comprises, at portion 61, a through opening 33 in which a U-shaped conducting strip 65 projects from body 3; along at least one edge, strip 65 comprises at least one projecting faston contact 7 formed in one piece with strip 65; and a T-shaped end of strip 65 defines ground contact 7t, which, in this case, is substantially flush with portion 63 and located beneath opening 33.

At portion 63, bracket 9 comprises a peripheral flange 68, which rests against the outside of casing 2 and covers a through opening or seat 18a formed through casing 2. According to the invention, the width of body 3 is smaller than that defined by flange 68 about portion 63 of bracket 9 (width in horizontal section of portion 63) so that body 3, complete with the wiring for connecting contacts 7 and the filter to the mains, is insertable from the outside through opening 18a into casing 2, opening 18a is closed by portion 63 and flange 68 of bracket 9 by rotating assembly 100 to align body 3 with casing 2, at a given distance from the inner side of casing 2, and bracket 9 is locked against casing 2 by tooth 17 and the other known snap-on fastening means (not shown), which, in the case, are provided only on portion 63.

## Claims

1. An integrated terminal board-filter assembly, in particular for electric household appliances, comprising a main body (3) made of electrically insulating material and defining an inner cavity (4) housing the preassembled, prewired components of an electronic filter (6); and a number of electric contacts; characterized by comprising:
- a bracket (9) projecting laterally from one end of the main body and also made of electrically insulating material; the bracket being formed integrally in one piece with the main body; and said number of electric contacts (7) being provided at and integral with the bracket, and so as to be connected electrically to the components of the filter (6);
- a cable clamping device (11) formed integrally in one piece with a free end of the bracket opposite the main body; and
- snap-on fastening means (15,17) for connecting the assembly to a support casing, and which are provided at least at said cable clamping device (11), on a mating surface connecting the assembly to the casing and defined by at least a respective face of the main body and/or the bracket.

2. A terminal board-filter assembly as claimed in Claim 1, characterized in that said number of electric contacts (7) comprise at least a ground contact (7t), which in turn comprises at least one hole for fitment to said casing, and is substantially flush with said mating surface.

3. A terminal board-filter assembly as claimed in Claim 2, characterized in that said number of electric contacts (7) project directly from said main body, on the same side as said bracket, and through a wall (30) of the main body from which and with which the bracket extends in one piece.

4. A terminal board-filter assembly as claimed in Claim 2 or 3, characterized in that said faces of the main body and the bracket both comprise said snap-on fastening means (15), and are flush with each other so as to form a single continuous mating surface for connection to said casing.

5. A terminal board-filter assembly as claimed in Claim 4, characterized in that said ground contact (7t) comprises a flat T-shaped tab (31) coplanar with said bracket and substantially flush with said mating surface of the assembly; said T-shaped tab being housed inside a through opening formed in said bracket and flush with said wall of the main body from which the bracket projects and through which the T-shaped tab projects from the main body into said through opening.

6. A terminal board-filter assembly as claimed in Claim 5, characterized in that said T-shaped tab (31) comprises two opposite through holes (35) for fitment to the casing and formed through the ends of the wings of the T; on a common front edge of said wings, said T-shaped tab comprising at least one projecting faston type contact formed in one piece with the T-shaped tab.

7. A terminal board-filter assembly as claimed in Claim 2 or 3, characterized in that said bracket is in the form of a right-angle Z-shaped stirrup comprising a first flat portion (61) projecting from the main body and flush with said face of the main body, a second portion (62) perpendicular to the first portion, and a third portion (63) parallel to the first portion and projecting from the second portion, on the opposite side to the first portion; an upper face, facing the main body, of said third portion defining said mating surface.

8. A terminal board-filter assembly as claimed in Claim 7, characterized in that said bracket comprises, at said first portion (61), a through opening in which a U-shaped conducting strip (65) projects from said main body; said conducting strip having, along at least one edge, at least one projecting faston type contact formed in one piece with the conducting strip; and one end of said conducting strip defining said ground contact, being substantially flush with said third portion of the bracket, and being located beneath said through opening.

9. A terminal board-filter assembly as claimed in Claim 8, characterized in that said bracket, at said third portion (63), comprises a peripheral flange (68), which rests against said casing; and in that said main body is of a width smaller than that defined by said flange about said third portion of the bracket, so that the main body, complete with the wiring for connecting said contacts and said filter to the mains, is insertable from the outside inside said casing through an opening formed in the casing and which, in use, is closed by said flange.

10. A terminal board-filter assembly as claimed in one of the foregoing Claims, characterized in that said main body is open laterally, and more specifically on the opposite side (38), to said bracket, to enable access to said cavity; said cavity being filled with a solid insulating resin in which said components of said electronic filter are embedded.

11. A terminal board-filter assembly as claimed in any one of the foregoing Claims, characterized in that said main body (3) is substantially parallelepiped; said bracket projecting from the main body, parallel to and on the opposite side to the open side of the main body; two ribs (52) for protecting the contacts being provided at said through opening, on opposite longitudinal sides of said bracket; and said two ribs projecting from the main body, in one piece with the main body and the bracket, and tapering towards the free end of the bracket.

12. A terminal board-filter assembly as claimed in any one of the foregoing Claims, characterized by comprising a second number of contacts (37) projecting from said main body through a lateral wall (38) of the main body opposite the wall from which said bracket extends.

13. A terminal board-filter assembly as claimed in any one of the foregoing Claims, characterized in that said cable clamping (11) device comprises a sleeve element (21) formed in one piece through and perpendicularly to said bracket, and having an inner through seat for an electric supply cable and, to the side, a nut screw; and a wedge-shaped cable clamping element, which is inserted gradually inside said seat, alongside the cable, by means of a screw screwed inside said nut screw; the cable clamping element being connected laterally in one piece to the bracket by a flexible tongue (28).

## Patentansprüche

1. Anschlussvorrichtung mit integriertem Entstörfilter, insbesondere für elektrische Haushaltsgeräte, umfassend einen Hauptkörper (3), der aus elektrisch isolierendem Material besteht und einen inneren Hohlraum (4) definiert, der die vormontierten, vorverdrahteten Komponenten eines elektronischen Filters (6) aufnimmt; und eine Anzahl elektrischer Kontakte; dadurch gekennzeichnet, daß es umfaßt:
- einen Ausleger (9), der seitlich von einem Ende des Hauptkörpers absteht und auch aus elektrisch isolierendem Material besteht; wobei der Ausleger einstückig integriert mit dem Hauptkörper gebildet ist; und die Anzahl elektrischer Kontakte (7) an und integriert mit dem Ausleger vorgesehen ist, so daß sie elektrisch an die Komponenten des Filters (6) angeschlossen werden können;
- eine Kabelklemmvorrichtung (11), die einstückig integriert mit einem freien Ende des Auslegers gegenüber dem Hauptkörper ausgebildet ist; und
- Schnappbefestigungsmittel (15, 17) für den Anschluß der Anordnung an ein tragendes Gehäuse, die zumindest an der Kabelklemmvorrichtung (11) an einer Paßfläche vorgesehen sind, welche die Anordnung mit dem Gehäuse verbindet und durch mindestens eine entsprechende Fläche des Hauptkörpers und/oder des Auslegers definiert ist.

2. Anschlussvorrichtung mit Entstörfilter nach Anspruch 1, dadurch gekennzeichnet, daß die Anzahl von elektrischen Kontakten (7) zumindest einen Erdungskontakt (7t) umfaßt, der seinerseits mindestens eine Öffnung zur Befestigung an dem Gehäuse umfaßt, und im wesentlichen mit der Paßfläche in einer Ebene liegt.

3. Anschlussvorrichtung mit Entstörfilter nach Anspruch 2, dadurch gekennzeichnet, daß die Anzahl von elektrischen Kontakten (7) direkt von dem Hauptkörper an derselben Seite wie der Ausleger und durch eine Wand (30) des Hauptkörpers absteht, von welcher und mit welcher der Ausleger einstückig absteht.

4. Anschlussvorrichtung mit Entstörfilter nach Anspruch 2 oder 3, dadurch gekennzeichnet, daß die Flächen sowohl des Hauptkörpers als auch des Auslegers die Schnappbefestigungsmittel (15) enthalten und in derselben Ebene liegen, so daß sie eine einzige durchgehende Paßfläche zur Verbindung mit dem Gehäuse bilden.

5. Anschlussvorrichtung mit Entstörfilter nach Anspruch 4, dadurch gekennzeichnet, daß der Erdungskontakt (7t) eine flache, T-förmige Lasche (31) umfaßt, die koplanar mit dem Ausleger und im wesentlichen in einer Ebene mit der Paßfläche der Anordnung liegt; wobei die T-förmige Lasche im Inneren einer Durchgangsöffnung aufgenommen ist, die in dem Ausleger ausgebildet ist, und mit der Wand des Hauptkörpers in einer Ebene liegt, von welcher der Ausleger absteht und durch welche die T-förmige Lasche von dem Hauptkörper in die Durchgangsöffnung ragt.

6. Anschlussvorrichtung mit Entstörfilter nach Anspruch 5, dadurch gekennzeichnet, daß die T-förmige Lasche (31) zwei gegenüberliegende Durchgangslöcher (35) zur Befestigung an dem Gehäuse umfaßt, die in den Enden der Flügel des T ausgebildet sind; und einen gemeinsamen Vorderrand der Flügel, wobei die T-förmige Lasche zumindest einen vorstehenden FASTON-artigen Kontakt umfaßt, der einstückig mit der T-förmigen Lasche ausgebildet ist.

7. Anschlussvorrichtung mit Entstörfilter nach Anspruch 2 oder 3, dadurch gekennzeichnet, daß der Ausleger die Form eines rechtwinkligen, Z-förmigen Bügels aufweist, umfassend einen ersten flachen Abschnitt (61), der von dem Hauptkörper absteht und in einer Ebene mit der Fläche des Hauptkörpers liegt, einen zweiten Abschnitt (62), der senkrecht zu dem ersten Abschnitt liegt, und einen dritten Abschnitt (63), der parallel zu dem ersten Abschnitt liegt und von dem zweiten Abschnitt an der dem ersten Abschnitt gegenüberliegenden Seite absteht; wobei eine obere Fläche des dritten Abschnittes, die zu dem Hauptkörper weist, die Paßfläche definiert.

8. Anschlussvorrichtung mit Entstörfilter nach Anspruch 7, dadurch gekennzeichnet, daß der Ausleger an dem ersten Abschnitt (61) eine Durchgangsöffnung umfaßt, in welche ein U-förmiger, leitender Streifen (65) von dem Hauptkörper ragt; wobei der leitende Streifen zumindest entlang einem Rand wenigstens einen vorstehenden Kontakt vom FASTON-Typ aufweist, der einstückig mit dem leitenden Streifen ausgebildet ist; und ein Ende des leitenden Streifens den Erdungskontakt definiert, der im wesentlichen in einer Ebene mit dem dritten Abschnitt des Auslegers liegt und unterhalb der Durchgangsöffnung angeordnet ist.

9. Anschlussvorrichtung mit Entstörfilter nach Anspruch 8, dadurch gekennzeichnet, daß der Ausleger an dem dritten Abschnitt (63) einen Umfangsflansch (68) umfaßt, der gegen das Gehäuse liegt; und daß der Hauptkörper eine geringere Breite aufweist als jene, die durch den Flansch um den dritten Abschnitt des Auslegers definiert ist, so daß der Hauptkörper, vollständig mit der Verdrahtung für den Anschluß der Kontakte und des Filters an das Hauptnetz, von außen in das Gehäuse durch eine Öffnung einsetzbar ist, die in dem Gehäuse ausgebildet ist, und die bei Gebrauch von dem Flansch verschlossen ist.

10. Anschlussvorrichtung mit Entstörfilter nach einem der vorangehenden Ansprüche, dadurch gekennzeichnet, daß der Hauptkörper seitlich offen ist, und insbesondere an der dem Ausleger gegenüberliegenden Seite (38), so daß ein Zugang zu dem Hohlraum möglich ist; wobei der Hohlraum mit einem festen Isolierharz gefüllt ist, in dem die Komponenten des elektronischen Filters eingebettet sind.

11. Anschlussvorrichtung mit Entstörfilter nach einem der vorangehenden Ansprüche, dadurch gekennzeichnet, daß der Hauptkörper (3) im wesentlichen quaderförmig ist; der Ausleger von dem Hauptkörper parallel zu dem Hauptkörper und an der Seite, die seiner offenen Seite gegenüberliegt, absteht; zwei Rippen (52) zum Schutz der Kontakte an der Durchgangsöffnung an gegenüberliegenden Längsseiten des Auslegers vorgesehen sind; und die zwei Rippen von dem Hauptkörper einstückig mit dem Hauptkörper und dem Ausleger abstehen und konisch zu dem freien Ende des Auslegers verlaufen.

12. Anschlussvorrichtung mit Entstörfilter nach einem der vorangehenden Ansprüche, dadurch gekennzeichnet, daß es eine zweite Anzahl von Kontakten (37) umfaßt, die von dem Hauptkörper durch eine Seitenwand (38) des Hauptkörpers abstehen, die jener Wand gegenüberliegt, von welcher der Ausleger absteht.

13. Anschlussvorrichtung mit Entstörfilter nach einem der vorangehenden Ansprüche, dadurch gekennzeichnet, daß die Kabelklemmvorrichtung (11) ein Kragenelement (21) umfaßt, das einstückig durch und senkrecht zu dem Ausleger geformt ist und einen inneren Durchgangssitz für ein elektrisches Versorgungskabel und an der Seite eine Schraubenaufnahme aufweist; sowie ein keilförmiges Kabelklemmelement, das schrittweise in den Sitz entlang des Kabels durch eine Schraube eingesetzt wird, die in die Schraubenaufnahme geschraubt wird; wobei das Kabelklemmelement durch eine biegsame Zunge (28) seitlich einstückig mit dem Ausleger verbunden ist.

## Revendications

1. Ensemble filtre-bornier intégré, en particulier pour des appareils électroménagers, comprenant un corps principal (3) fait d'une matière électriquement isolante et définissant une cavité intérieure (4) logeant les composants préassemblés, précâblés d'un filtre électronique (6) ; et un certain nombre de contacts électriques ; caractérisé en ce qu'il comprend :
- une console (9) dépassant latéralement à partir d'une extrémité du corps principal et également faite de matière électriquement isolante ; la console étant totalement formée d'un seul tenant avec le corps principal ; et ledit nombre de contacts électriques (7) étant disposés au niveau de la console et d'un seul tenant avec cette dernière, et de façon à être électriquement reliés aux composants du filtre (6) ;
- un dispositif de serrage de câble (11) totalement formé d'un seul tenant avec une extrémité libre de la console opposée au corps principal ; et
- des moyens de fixation par encliquetage (15, 17) pour relier l'ensemble à un boîtier de support, et qui sont disposés au moins au niveau dudit dispositif de serrage de câble (11), sur une surface d'accouplement reliant l'ensemble au boîtier et définie par au moins une face respective du corps principal et/ou de la console.

2. Ensemble filtre-bornier selon la revendication 1, caractérisé en ce que ledit nombre de contacts électriques (7) comprend au moins un contact de masse (7t) qui, à son tour, comprend au moins un trou pour l'installation dans ledit boîtier, et est sensiblement à fleur avec ladite surface d'accouplement.

3. Ensemble filtre-bornier selon la revendication 2, caractérisé en ce que ledit nombre de contacts électriques (7) dépasse directement dudit corps principal, du même côté que ladite console, et à travers une paroi (30) du corps principal à partir de laquelle et avec laquelle la console s'étend d'un seul tenant.

4. Ensemble filtre-bornier selon la revendication 2 ou 3, caractérisé en ce que lesdites faces du corps principal et de la console constituent toutes deux lesdits moyens de fixation par encliquetage (15), et sont à fleur l'une par rapport à l'autre de façon à former une seule surface d'accouplement continue pour la connexion audit boîtier.

5. Ensemble filtre-bornier selon la revendication 4, caractérisé en ce que ledit contact de masse (7t) comprend une languette plate (31) en forme de T coplanaire avec ladite console et sensiblement à fleur avec ladite surface d'accouplement de l'ensemble ; ladite languette en forme de T étant logée à l'intérieur d'une ouverture traversante formée dans ladite console et à fleur avec ladite paroi du corps principal à partir de laquelle la console dépasse et à travers laquelle la languette en forme de T dépasse du corps principal dans ladite ouverture traversante.

6. Ensemble filtre-bornier selon la revendication 5, caractérisé en ce que ladite languette (31) en forme de T comprend deux trous traversants opposés (35) pour une installation dans le boîtier et formés à travers les extrémités des ailes du T ; sur un bord avant commun desdites ailes, ladite languette en forme de T comprenant au moins un contact en saillie du type rapide formé d'un seul tenant avec la languette en forme de T.

7. Ensemble filtre-bornier selon la revendication 2 ou 3, caractérisé en ce que ladite console est sous la forme d'un étrier en forme de Z à angle droit comprenant une première partie plate (61) dépassant du corps principal et à fleur avec ladite face du corps principal, une deuxième partie (62) perpendiculaire à la première partie, et une troisième partie (63) parallèle à la première partie et dépassant de la deuxième partie, sur le côté opposé à la première partie ; une face supérieure, faisant face au corps principal, de ladite troisième partie définissant ladite surface d'accouplement.

8. Ensemble filtre-bornier selon la revendication 7, caractérisé en ce que ladite console comprend, au niveau de ladite première partie (61), une ouverture traversante dans laquelle une bande conductrice (65) en forme de U dépasse dudit corps principal ; ladite bande conductrice ayant, le long d'au moins un bord, au moins un contact en saillie du type rapide formé d'un seul tenant avec la bande conductrice ; et une extrémité de ladite bande conductrice définissant ledit contact de masse, étant sensiblement à fleur avec ladite troisième partie de la console, et étant située au-dessous de ladite ouverture traversante.

9. Ensemble filtre-bornier selon la revendication 8, caractérisé en ce que ladite console comprend, au niveau de ladite troisième partie (63), une bride périphérique (68), qui repose contre ledit boîtier ; et en ce que ledit corps principal a une largeur plus petite que celle définie par ladite bride autour de ladite troisième partie de la console, de sorte que le corps principal, au complet avec le câblage pour relier lesdits contacts et ledit filtre au secteur, peut être inséré à partir de l'extérieur à l'intérieur dudit boîtier à travers une ouverture formée dans le boîtier et qui, en fonctionnement, est fermée par ladite bride.

10. Ensemble filtre-bornier selon l'une quelconque des revendications précédentes, caractérisé en ce que ledit corps principal est ouvert latéralement, et de manière plus spécifique sur le côté opposé (38) à ladite console, pour permettre l'accès à ladite cavité ; ladite cavité étant remplie d'une résine isolante solide dans laquelle lesdits composants dudit filtre électronique sont noyés.

11. Ensemble filtre-bornier selon l'une quelconque des revendications précédentes, caractérisé en ce que ledit corps principal (3) est sensiblement parallélépipédique ; ladite console dépassant du corps principal, parallèlement et sur le côté opposé au côté ouvert du corps principal ; deux nervures (52) pour protéger les contacts étant prévues au niveau de ladite ouverture traversante, sur les côtés longitudinaux opposés de ladite console ; et lesdites deux nervures dépassant du corps principal, d'un seul tenant avec le corps principal et la console, et allant en s'amincissant vers l'extrémité libre de la console.

12. Ensemble filtre-bornier selon l'une quelconque des revendications précédentes, caractérisé en ce qu'il comprend un second nombre de contacts (37) dépassant dudit corps principal à travers une paroi latérale (38) du corps principal opposée à la paroi à partir de laquelle ladite console s'étend.

13. Ensemble filtre-bornier selon l'une quelconque des revendications précédentes, caractérisé en ce que ledit dispositif de serrage de câble (11) comprend un élément formant manchon (21) formé d'un seul tenant à travers et perpendiculairement à ladite console, et ayant un appui intérieur traversant pour un câble d'alimentation électrique et, sur le côté, un écrou ; et un élément de serrage de câble en forme de coin, qui est inséré progressivement à l'intérieur dudit appui, le long du câble, au moyen d'une vis vissée à l'intérieur dudit écrou ; l'élément de serrage de câble étant relié latéralement d'un seul tenant à la console par une patte souple (28).
